# EUROPÄISCHE PATENTANMELDUNG

(11) **EP 4 610 668 A1**
(43) Veröffentlichungstag der Anmeldung: **03.09.2025**
(21) Anmeldenummer: 25160176.1
(22) Anmeldetag: 26.02.2025
(51) Int. Cl.: G01R 13/40, G01R 19/25, G01R 19/155

(54) **SCHALTUNGSANORDNUNG IN EINEM GLEICHSPANNUNGSPRÜFSYSTEM**

(30) Priorität: 01.03.2024 DE 102024106022
(71) Anmelder: H. Horstmann GmbH, 42579 Heiligenhaus (DE)
(72) Erfinder: WÜRSIG, Holger, 47239 Duisburg (DE)
(74) Vertreter: Taruttis, Tilman

(57) **Zusammenfassung**

Gleichspannungsprüfsystem zur Anzeige einer Spannung, wobei das Gleichspannungsprüfsystem einen Schwellwertschalter, einen damit verbundenen Oszillator sowie ein mit dem Oszillator verbundenes Flüssigkristallanzeigesegment zur Anzeige eines Zustands der Gleichspannung umfasst, d.h. ob die Gleichspannung über oder unter einem Schwellwert liegt.

## Beschreibung

Die Erfindung betrifft ein Gleichspannungsprüfsystem, insbesondere für Gleichspannungen von mehr als 100 Volt in einem Mittel oder Hochspannungssystem, wobei eine Spannung mittels eines Flüssigkristallanzeigesegments angezeigt wird.

Elektrische Energie wird über Verteilsysteme von einem Energieerzeuger zu einem Verbraucher transportiert. In den meisten Fällen wird die elektrische Energie aus praktischen Gründen in Form von Dreiphasenwechselspannung übertragen, beispielsweise in sogenannten Verbundnetzen. Für bestimmte Bereiche wird elektrische Energie jedoch als Gleichspannung übertragen und verteilt, beispielsweise in Verteilnetzen für Straßenbahnen, wobei Gleichspannungen bis 3000V verwendet werden.

Für die Anzeige von Gleichspannungen sind Spannungsprüfsysteme bekannt, welche typischerweise LEDs zur Anzeige verwenden. Angezeigt wird beispielsweise, ob ein Leiter spannungsfrei ist oder Spannung führt, d.h. ob eine zu messende Spannung über oder unter einem Schwellwert liegt. Für das Anzeigen mittels LED wird typischerweise elektrische Energie in einem Ladekondensator gespeichert, die über eine Schwellwertschaltung oder ein Schaltelement schlagartig über eine LED entladen wird. Die Ströme, welche in dem Moment fließen, wenn die Diode zu leiten beginnt, sind jedoch vergleichsweise hoch und haben eine unerwünschte Rückwirkung auf einen typischerweise vorgelagerten Spannungsteiler.

Aus dem Stand der Technik ist eine Schaltungsanordnung bekannt, beispielsweise aus der DE 42 41 975 C1, welche eine Flüssigkristallanzeige, sogenanntes Flüssigkristallanzeigesegment, für die Anzeige eines Ladezustands einer Batterie mit zwei Batteriezellen verwendet, wobei die Schaltungsanordnung aus der Batterie gespeist wird. Die beschriebene Schaltungsanordnung umfasst dabei einen Komparator sowie einen Oszillator mit jeweils invertierten Ausgängen und damit erheblichen Schaltungsaufwand.

Damit ergibt sich die Aufgabe ein Gleichspannungsprüfsystem bereitzustellen, welches insbesondere für Spannungen von mehreren Hundert Volt geeignet ist, und welches die für das Gleichspannungsprüfsystem notwendige Energie aus dem Messsignal bezieht, sodass eine separate Energieversorgung des Prüfsystems eingespart werden kann.

Diese Aufgabe wird mit einem Gleichspannungsprüfsystem gemäß dem unabhängigen Anspruch 1 gelöst. Weitere vorteilhafte Ausführungsformen sind in den abhängigen Ansprüchen genannt.

Im Folgenden wird die Erfindung anhand von Figuren beschrieben, dabei zeigen:
- Fig. 1: eine schematische Darstellung eines Spannungsprüfsystems,
- Figs. 2a, b: eine schematische Darstellung einer Ansteuerung eines Flüssigkristallanzeigesegments,
- Fig. 3: eine Ausführungsform eines Schwellwertschalters,
- Fig. 4: eine Ausführungsform einer Oszillatorschaltung zur Erzeugung differentieller Signale,
- Fig. 5: eine schematische Darstellung der von der Oszillatorschaltung erzeugten differentiellen Signale.

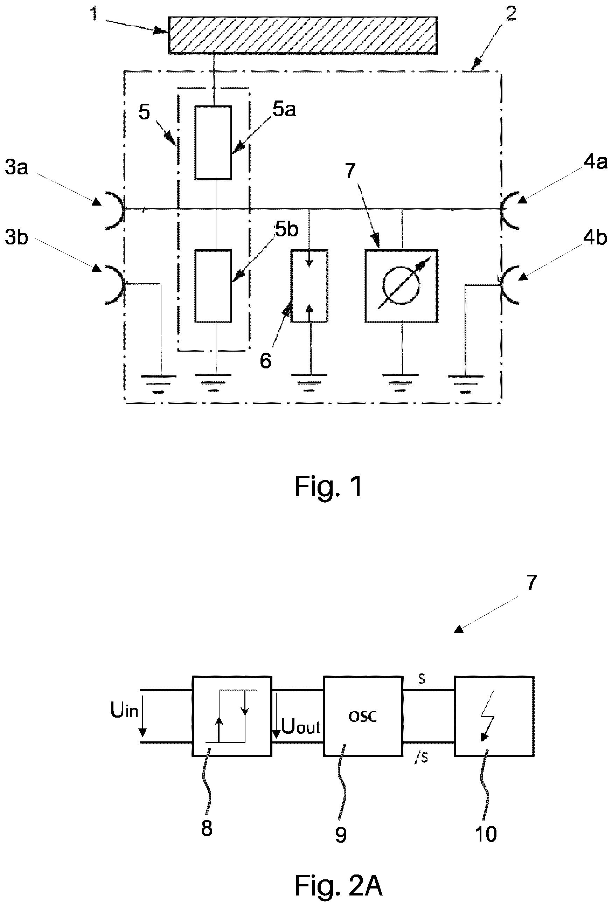

Fig. 1 zeigt eine Leitung 1 einer Gleichspannungsverteilebene, die eine Gleichspannung von mehr als 100 Volt, insbesondere mindestens 600 Volt oder mehr führt, so wie dies beispielsweise bei Oberleitungen von Straßenbahnen oder anderen Verteilnetzen beispielsweise in Europa der Fall sein kann. In anderen Verteilsystemen, beispielsweise in der Mittelspannungsebene, kann die Gleichspannung auch mehrere kV betragen.

Die Leitung 1 ist mit einem Gleichspannungsprüfsystem 2 verbunden, welches anzeigt, ob die Leitung 1 eine Spannung gegenüber einem Bezugspotential führt, die höher als ein vorgegebener Schwellwert ist. Typischerweise gilt die Leitung 1 als frei von Spannung, wenn diese unterhalb des Schwellwerts ist. Die Anzeige des Spannungsprüfsystems 2 signalisiert damit, ob eine Spannung der Leitung 1 größer oder gleich dem vorgegebenen Schwellwert ist. Das Bezugspotential ist hier als Erdpotential angenommen, wie in Fig. 1 dargestellt.

Das Spannungsprüfsystem 2 umfasst optional ein erstes und ein zweites Paar Anschlüsse 3a, 3b und 4a, 4b, von denen jeweils ein Anschlusspunkt mit einer heruntergeteilten Gleichspannung und der andere mit dem Bezugspotential verbunden ist. Typischerweise sind die Anschlüsse des Anschlusspaares 3a, 3b auf der Rückseite des Gleichspannungsprüfsystems 2 angeordnet und dafür vorgesehen, dass ein weiteres und in der Figur nicht dargestelltes Messgerät fest angeschlossen werden kann. Das Paar Anschlüsse 4a, 4b ist typischerweise auf der Frontseite des Systems platziert und dafür vorgesehen, dass ein alternatives Messgerät angeschlossen wird, beispielsweise um die Funktion des Gleichspannungsprüfsystems 2 zu prüfen.

Das Spannungsprüfsystem 2 umfasst einen Spannungsteiler 5, optional ein spannungsbegrenzendes Element 6 und eine Anzeige 7, die eine dazugehörige Ansteuerung umfasst.

Der Spannungsteiler 5 umfasst einen ohmschen Widerstand 5a, der mit seinem einen Ende mit dem spannungsführenden Element 1 und an seinem anderen Ende mit der Anzeige 7 sowie mit einem optionalen weiteren ohmschen Widerstand 5b verbunden ist. Der Spannungsteiler 5 ist dabei so dimensioniert, dass die Spannung des spannungsführenden Elements 1, also die zu prüfende Spannung, auf einen für das Gleichspannungsprüfsystem angemessenen Wertebereich angepasst wird. Die Anzeige 7 des Gleichspannungsprüfsystems ist parallel zu dem zweiten ohmschen Widerstand 5b geschaltet. Entfällt der zweite ohmsche Widerstand 5b, so bildet die Anzeige 7 des Gleichspannungsprüfsystems 2 den zweiten Widerstand des Spannungsteilers.

Optional umfasst das Gleichspannungsprüfsystem 2 auch ein spannungsbegrenzendes Element 6, einen sogenannten Spannungsbegrenzer, welcher die Spannung nach dem Spannungsteiler 5 begrenzt. Das spannungsbegrenzende Element 6 ist typischerweise so dimensioniert, dass die nachfolgend beschriebene Anzeige 7 vor einer Überspannung geschützt ist.

Die Anzeige 7 umfasst eine Ansteuerungsschaltung für eine Flüssigkristallanzeige 10 sowie die Flüssigkristallanzeige, wobei die Ansteuerungsschaltung einen Schwellwertschalter 8 und einen Oszillator 9 umfasst.

Figur 2a zeigt eine erste Ausführungsform der Anzeige 7, wobei die Anzeige 7 einen Schwellwertschalter 8 aufweist, der mit der spannungsgeteilten Spannung Uᵢₙ sowie dem Bezugspotential verbunden ist, sowie einen mit dem Schwellwertschalter 8 verbundenen Oszillator 9 und ein damit verbundenes Flüssigkristallanzeigesegment 10. Die durch den Spannungsteiler 5 heruntergeteilte Spannung liegt als Eingangsspannung Uᵢₙ an dem Schwellwertschalter 8 an. Der Schwellwertschalter 8 schaltet in dieser Ausführungsform mit einer Hysterese, sodass am Ausgang des Schwellwertschalters 8 eine Spannung Uₒᵤₜ anliegt, wenn die Eingangsspannung Uᵢₙ höher als ein erster Schwellwert ist und noch nicht wieder unter einen zweiten Schwellwert gefallen ist. Die Ausgangsspannung Uₒᵤₜ fällt wieder auf das Bezugspotential, wenn die Eingangsspannung Uᵢₙ unter den zweiten Schwellwert fällt, wobei der zweite Schwellwert kleiner als der erste Schwellwert ist.

Die Oszillatorschaltung 9 erzeugt an seinem Ausgang differentielle Signale S und /S, sobald die Spannung Uₒᵤₜ an dem Eingang der Oszillatorschaltung 9 anliegt. Die differentiellen Signale S und /S sind die Eingangssignale des Flüssigkristallanzeigesegments 10. Sobald diese anliegen, zeigt das Flüssigkristallanzeigesegment 10 ein Symbol an, beispielsweise einen Pfeil, der das Anliegen einer Spannung signalisiert.

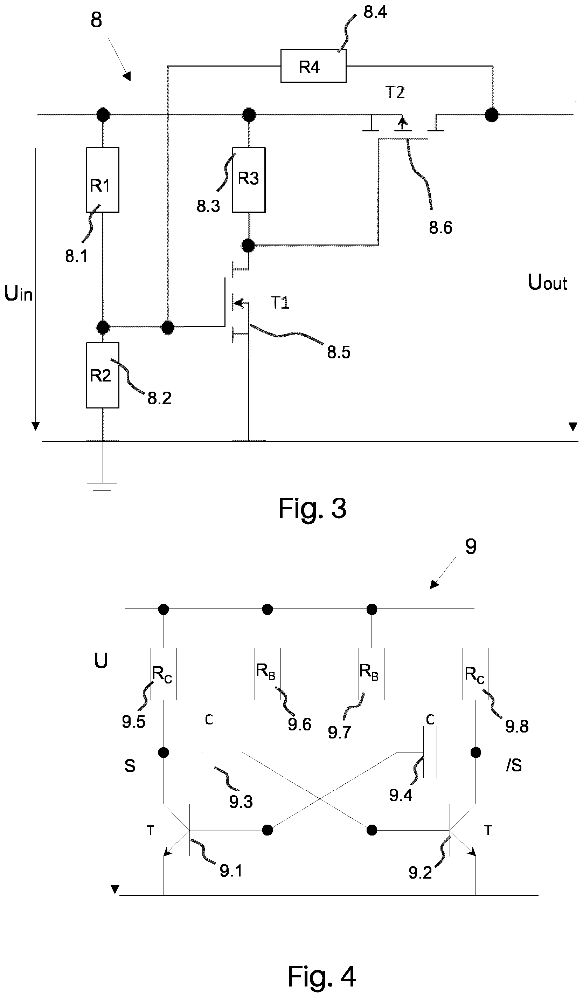

Fig. 3 zeigt schematisch eine Ausführungsform einer Schaltung des Schwellwertschalters 8, wobei der Schwellwertschalter 8 in dieser Ausführungsform eine Hysterese aufweist. Der Schwellwertschalter 8 besteht hier aus den ohmschen Widerständen R1 bis R4, entsprechend Bezugszeichen 8.1 bis 8.4, sowie einem n-Kanal Feldeffekttransistor T1, Bezugszeichen 8.5, und einem p-Kanal Feldeffekttransistor T2, Bezugszeichen 8.6. Die Widerstände R1 und R2 bilden einen Spannungsteiler, wobei das Gate des n-Kanal FET an die geteilte Spannung und über den Widerstand R4, 8.4, mit der Ausgangsspannung Uₒᵤₜ verbunden ist. Source des n-Kanal FET 8.5 ist mit dem Bezugspotential und Drain des n-Kanal FET 8.5 ist mit dem Gate des p-Kanal FET 8.6 direkt und über den ohmschen Widerstand R3, 8.3, mit der Eingangsspannung Uᵢₙ verbunden. Source des p-Kanal FET, 8.6, ist ebenso mit der Eingangsspannung Uᵢₙ verbunden, Drain des p-Kanal FET ist mit der Ausgangsspannung Uₒᵤₜ verbunden. Über das Verhältnis der Widerstände R1 bis R4 können in bekannter Weise die Umschaltpunkte der Hysterese des Schwellwertschalters eingestellt werden. Die Ausgangsspannung Uₒᵤₜ des Schwellwertschalters entspricht dabei der Eingangsspannung Uᵢₙ des Schwellwertschalters abzüglich des Spannungsabfalls über die Drain-Source Strecke des p-Kanal FET 8.6.

Fig. 4 zeigt schematisch das Schaltbild des Oszillators 9. Die Ausgangsspannung Uₒᵤₜ des Schwellwertschalters 8 ist die Eingangsspannung U_{osc} des Oszillators 9.

Der Oszillator ist hier eine an sich bekannte astabile Kippstufe, die hier aus zwei bipolaren npn-Transistoren, 9.1 - 9.2, sowie zwei Kapazitäten, 9.3 - 9.4, zwei ohmschen Kollektorwiderstanden R_{C}, 9.5 und 9.8, sowie zwei ohmschen Basiswiderständen R_{B}, 9.6 und 9.7 symmetrisch aufgebaut ist. Die Basiswiderstände R_{B}, 9.6 und 9.7, sind dabei so gewählt, dass die Transistoren 9.1 und 9.2 ausreichend Strom erhalten, um durchsteuern zu können. Die Kollektorwiderstände 9.5 und 9.8 begrenzen den Kollektorstrom. Der Oszillator beginnt zu schwingen, sobald einen ausreichend große Eingangsspannung U_{osc} anliegt, wobei die Frequenz des Oszillators durch die RC-Glieder R_{B}C festgelegt ist. Die erzeugten differentiellen Ausgangssignale S und /S werden an den Kollektoren der Transistoren 9.1 und 9.2 abgenommen und steuern das Flüssigkristallanzeigesegment 10 an.

Das Flüssigkristallanzeigesegment zeigt damit das Symbol an, sobald die differentiellen Signale S und /S anliegen, d.h. wenn am Ausgang des Schwellwertschalters 8 die Ausgangsspannung Uₒᵤₜ anliegt und infolgedessen der Oszillator 9 die differentiellen Signale S und /S erzeugt und diese das Flüssigkristallanzeigesegment ansteuern.

Die Bauelemente des Oszillators 9 sind dabei so konfiguriert, dass die Spannung sowie Frequenz der erzeugten differentielle Signale zur Ansteuerung des Flüssigkristallanzeigesegments 10 geeignet sind und gleichzeitig die Ansteuerung möglichst wenig Strom benötigt.

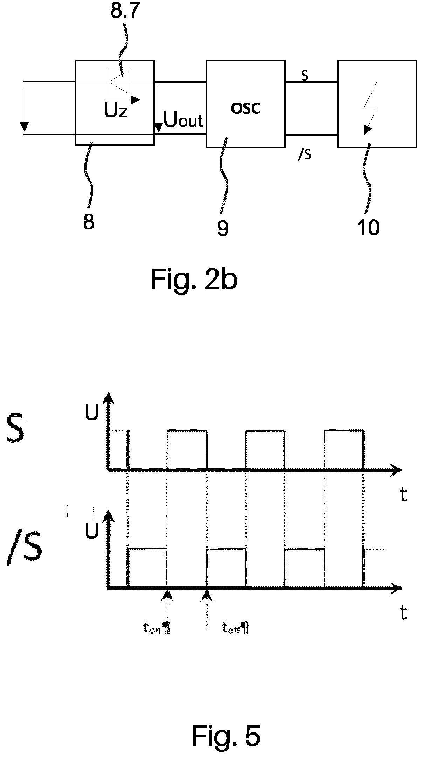

Fig. 5. zeigt schematisch die differentiellen Signale S und /S, die von dem Oszillator 9 erzeugt werden, wenn am Eingang des Oszillators 9 eine ausreichende Spannung anliegt. Die Figur zeigt, dass die Signale S und /S differentielle Signale sind, d.h. wenn das Signal S größer Null anliegt, so ist das Signal /S gleich Null. Ebenso andersherum ist das Signal S gleich Null, wenn das Signal /S größer Null ist. Beide Signale sind aufgrund des symmetrischen Aufbaus der Oszillatorschaltung 9 identisch, jedoch um eine halbe Signalperiode zueinander zeitverschoben.

Fig. 2b zeigt eine alternative Ausführungsform eines Schwellwertschalters 8. In dieser Ausführungsform ist der Schwellwertschalter 8 durch eine Zenerdiode 8.7 mit entsprechender Durchbruchspannung U_{Z} verwirklicht. Die Schwellwertspannung, ab der am Ausgang des Schwellwertschalters 7 die Spannung Uₒᵤₜ anliegt, ist die Durchbruchspannung U_{Z} der Zenerdiode 8.7. Die dargestellte Zenerdiode 8.7 kann dabei durch eine serielle Schaltung von mehreren Zenerdioden implementiert werden. Die oben beschriebene Schwellwertschaltung mit Hysterese ist damit durch die Zenerdiode 8.7 ersetzt. Der Schwellwertschalter 8 weist damit keine Hysterese auf. Die Zenerdiode 8.7 liefert im Falle des Überschreitens der Durchbruchspannung dann anodenseitig eine Spannung Uₒᵤₜ = Uᵢₙ - U_{z}, wobei Uz die Durchbruchspannung der Zenerdiode 8.7 ist.

### Bezugszeichenliste

- 1: spannungsführendes Element
- 2: Gleichspannungsprüfsystem
- 3a, 3b: Anschlusspunkt auf der Rückseite des Geräts zum festen Anschluss eines weiteren (Mess-)geräts
- 4a, 4b: Anschlusspunkt für Anwender auf Frontseite des Geräts zugänglich (alternative Messmethode kann angeschlossen werden -> Überprüfung des Spannungsprüfsystems 2
- 5: Spannungsteiler
- 5a: ohmscher Widerstand
- 5b: optionaler ohmscher Widerstand
- 6: spannungsbegrenzendes Element
- 7: Anzeige
- 8: Schwellwertschalter
- 8.1-8.4: ohmscher Widerstand
- 8.5: n-Kanal Feldeffekttransistor
- 8.6: p-Kanal Feldeffekttransistor
- 8.7: Zenerdiode
- 9: Oszillatorschaltung
- 9.1, 9.2: bipolarer npn-Transistor
- 9.3, 9.4: Kapazität
- 9.5-9.8: ohmscher Widerstand
- 10: Flüssigkristallanzeigesegment

## Patentansprüche

1. Gleichspannungsprüfsystem (2) zur Anzeige einer Gleichspannung, umfassend einen mit dem Gleichspannung führenden Element (1) verbundenen Spannungsteiler (3), und
einen mit dem Spannungsteiler (3) verbundenen Schwellwertschalter (8), wobei der Schwellwertschalter (8) eine Gleichspannung (Uₒᵤₜ) ausgibt, wenn eine vorbestimmte Schwellwertspannung (Uᵢₙ) überschritten ist, und
einen mit dem Schwellwertschalter (8) verbundene Oszillatorschaltung (9), wobei die Oszillatorschaltung (9) differentielle Signale (S, /S) zur Ansteuerung einer Flüssigkristallanzeige (10) erzeugt, sobald die vom Schwellwertschalter ausgegebene Gleichspannung (Uₒᵤₜ) an dem Eingang der Oszillatorschaltung anliegt, und
die mit der Oszillatorschaltung (9) verbundene Flüssigkristallanzeige (10) nur dann eine Anzeige anzeigt, wenn die differentiellen Signale der Oszillatorschaltung (9) an der Flüssigkristallanzeige (10) anliegen.

2. Gleichspannungsprüfsystem (2) nach Anspruch 1, wobei der Schwellwertschalter (8) eine Hysterese aufweist.

3. Gleichspannungsprüfsystem (2) nach Anspruch 2, wobei der Schwellwertschalter (8) einen ersten sowie einen zweiten Feldeffekttransistor (8.5, 8.6) aufweist.

4. Gleichspannungsprüfsystem (2) nach Anspruch 3, wobei der aus einem p-Kanal Feldeffekttransistor (8.6) und einem n-Kanal Feldeffekttransistor (8.5) und vier ohmschen Widerständen (8.1, 8.2, 8.3, 8.4) besteht.

5. Gleichspannungsprüfsystem (2) nach Anspruch 1, wobei der Schwellwertschalter (8) eine Zenerdiode (8.7) ist.

6. Gleichspannungsprüfsystem (2) nach einem der vorstehenden Ansprüche, wobei die Oszillatorschaltung (9) eine astabile Kippstufe und symmetrisch aufgebaut ist.

7. Gleichspannungsprüfsystem (2) nach Anspruch 6, wobei die Oszillatorschaltung (9) einen ersten sowie einen zweiten bipolaren Transistor (9.1, 9.2) sowie ein erstes und ein zweites RC-Glied aufweist, wobei das erste RC-Glied (9.6, 9.4) die Basis ersten bipolaren Transistors (9.1) und das zweite RC-Glied (9.7, 9.3) die Basis des zweiten bipolaren Transistors (9.2) ansteuert.

8. Gleichspannungsprüfsystem (2) nach einem der vorstehenden Ansprüche, wobei das Gleichspannungsprüfsystem (2) ein aus einem Gehäuse des Gleichspannungsprüfsystems (2) herausgeführtes Paar Anschlüsse aufweist, wobei ein Anschluss das Bezugspotential und der andere Anschluss eine heruntergeteilte Gleichspannung des Spannungsteilers (3) führt.

9. Gleichspannungsprüfsystem (2) nach einem der vorstehenden Ansprüche, wobei der Spannungsteiler (5) nur einen ohmschen Widerstand (5a) aufweist.

10. Gleichspannungsprüfsystem (2) nach einem der vorstehenden Ansprüche, wobei das Gleichspannungsprüfsystem (2) ein spannungsbegrenzendes Element (6) umfasst, welches die heruntergeteilte Spannung des Spannungsteilers (5) begrenzt.

11. Gleichspannungsprüfsystem (2) nach einem der vorstehenden Ansprüche, wobei die Gleichspannung mehr als 100 Volt, insbesondere mindestens 300 Volt oder mehr als 600 Volt oder mehr als 1500 Volt ist.
